# EUROPEAN PATENT SPECIFICATION

(11) **EP 0 522 680 B1**
(45) Date of publication and mention of the grant of the patent: **22.05.1996**
(21) Application number: 92302426.9
(22) Date of filing: 20.03.1992
(51) Int. Cl.: H05K 13/00, H01L 21/00

(54) **Micro-chip storage tape**
Speicherband zum Halten von Mikrochips
Ruban de stockage pour des microplaquettes

(30) Priority: 08.07.1991 US 726748
(43) Date of publication of application: 13.01.1993
(73) Proprietor: Advantek, Inc., Minnetonka, Minnesota 55343 (US)
(72) Inventor: Chenoweth, Dean B., Eden Prairie, Minnesota 55346 (US)
(74) Representative: SERJEANTS

(56) References cited:
- EP-A- 0 170 043
- EP-A- 0 265 873
- WO-A-90/04915
- TECHNICAL DISCLOSURE BULLETIN vol. 33, no. 10A, March 1991, NY,US pages 427 - 428; 'Multi-purpose plastic tray for plastic flat packages'

## Description

### FIELD OF THE INVENTION

The invention relates to tapes having pockets for storage of electronic integrated circuit components, such as microchips.

### BACKGROUND OF THE INVENTION

Commonly, microchips having a general rectangular shape are stored in trays. The trays have adjacent recesses to accommodate the microchips. These trays can be stacked on top of each other. This provides nominal protection to the delicate wire leads projecting from the sides of the microchip. Microchip movement within the trays is relatively unrestricted. This may cause inadvertent damage to the leads. Further, detection of placement and location of the microchips within the tray is not possible.

International Patent Application No. WO90/04915 discloses a storage tape for the storage of electronic flatpacks or microchips in individual moulded trays arranged longitudinally along the tape. Each tray is a recess moulded into the tape, and support means for the microchip are moulded integrally with the recess. The support means comprise protrusions arranged in rectilinear fashion around the recess, upstanding from the floor of the recess. The protrusions define a support surface or rectilinear platform for supporting the microchip above the floor of the recess along all its edges, and a ridge extending along the peripheral boundary of the support surface. In use the microchip rests on the support surface; it is restrained from lateral movement by the ridge; and cranked connector pins or leads extending from the microchip extend over the ridge and depend into the well of the recess formed around the rectilinear platform and ridge.

International Patent Application No. WO90/04915 teaches that the support surface may be continuous, around the whole of the outline of the microchip to be supported, or may be provided to support the microchip along its edges only, with no support at the corners. The present invention is based on the realization that the most important area for support for the microchip is at the corners, and that a significantly improved storage tape can be provided by departing from the teaching of W090/04915 and providing the vertical support for the microchip at the corners only.

EP-A-265873 discloses a holder for a single packaged integrated circuit component that has "J" leads, as opposed to projecting leads. That holder, which is a precision moulding from electrically conductive plastic, holds the packaged component at its corners only, so as to leave the "J" leads exposed for testing. The holder design of EP-A-265873 is rigid in nature , apart from the snap arms 44,46.

### SUMMARY OF THE INVENTION

The invention provides a storage tape for accommodating electronic integrated circuit components which are packaged with projecting leads, the tape comprising an elongated strip member having a longitudinal row of recesses for storing the components, each recess having side walls and a bottom wall but an open top, and having
vertical support means for providing vertical support for the component to be housed in the recess, to locate the component over the bottom wall so that its leads are spaced from and free from contact with the bottom wall, and
lateral support means for providing lateral support for the component to be supported on the vertical support means, to locate the component within a centre portion of the recess with the leads free from contact with the side walls, the lateral support means comprising a plurality of ridges upstanding from the bottom wall, parallel to and spaced from the side walls, each ridge having an inwardly facing inclined face and opposite end faces, the end faces of each pair of adjacent ridges being mutually spaced apart,
CHARACTERISED IN THAT
the vertical support means bridges the spacing between the mutually spaced end faces of the adjacent ridges and is connected to the bottom wall by upstanding walls extending diagonally between adjacent end faces of the ridges from the bottom wall to the vertical support means.

The invention is also directed to the combination of a storage tape as claimed and one or more packaged integrated circuit components accommodated in the recesses therein.

The storage tape of the invention is suitable for storing microchips which are rectangular in plan view, and for storing microchips which have corner lobes extending outwardly beyonmd the outline of the connecting pins or lead, to provide protection for those leads. One very significant advantage of the storage tape of the invention is that the same storage tape can accommodate both common styles of microchip: those with corner lobes and those without corner lobes. Another important advantage is that because the vertical support means bridge the distance between spaced end walls of adjacent ridges of the lateral support means, the vertical support means and lateral support means together form a continuous reinforcement for the bottom wall of the recess. As the tape of the invention is handled, there is a strong tendency for the user to twist it. If the vertical and lateral support means were discontinuous, as in Figure 1 of WO 90/04915, such twisting would cause the recess to flex along diagonal lines that extend between the spaced ends of opposite pairs of the support means. Such flexure causes misalignment of the microchip which can remain in an incorrect attitude in the recess even when the tape is again straightened.

### DESCRIPTION OF THE DRAWING

Figure 1 is a perspective view of part of a tape carrying a microchip;
Figure 2 is a top plan view of part of the tape of Figure 1;
Figure 3 is a sectional view taken along the line 3-3 of Figure 2;
Figure 4 is a sectional view taken along the line 4-4 of Figure 2;
Figure 5 is a sectional view taken along line 5-5 of Figure 2;
Figure 6 is an enlarged sectional view taken along the line 6-6 of Figure 1; and
Figure 7 is an enlarged sectional view taken along line 7-7 of Figure 1;

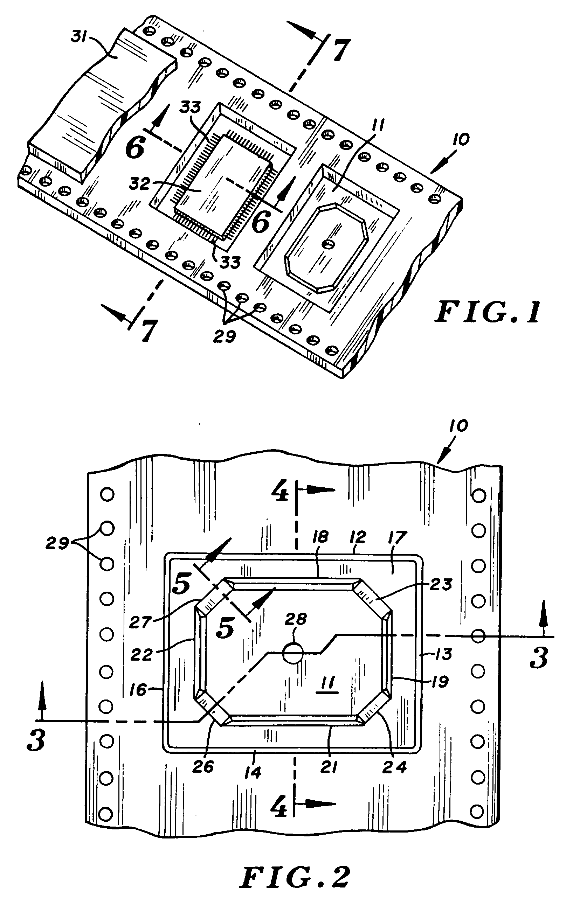

Referring to Figure 1, there is shown a tape of the invention, indicated generally at 10, for accommodating electronic parts, such as microchips. Tape 10 stores the microchips while preventing damage to the leads connected to the microchips. Optical readings can be made through tape 10 to determine whether the microchips are in the pockets or recesses in the tape.

Tape 10 is an elongated strip made of semi-flexible material, such as plastic and the like. A plurality of laterally spaced holes 29 extend through tape 10 adjacent the edges of the tape. Holes 29 can accommodate sprockets of a wheel (not shown) to allow tape 10 to be wound on and unwound from the wheel. Tape 10 has a plurality of laterally spaced rectangular pockets or recesses 11 that are centered between holes 29. Each recess 11 is adapted to accommodate a generally rectangular electronic part, such as a microchip 32 which has corner lobes 35, without damaging leads 33 connected to the microchip. A generally flat cover strip 31 releasably attached to the top surface of tape 10 closes recesses 11. Cover 31 holds microchips 32 within recesses 11 when tape 10 is wound on and unwound from a reel (not shown). An example of a tape reel is disclosed by D.B. Chenoweth in U.S. Patent No. 4,726,534. Recesses 11 can have other shapes to accommodate microchips of various sizes and shapes.

Referring to Figures 2 to 4, each recess 11 has a pair of downwardly directed side walls 12 and 14 that extend between downwardly directed end walls 13 and 16. The lower ends of walls 12, 13, 14 and 16 are joined to the outer peripheral edges of a generally rectangular bottom wall 17 to form recess 11. Bottom wall 17 has a plurality of upwardly projected ridges 18, 19, 21 and 22 for positioning microchip 32 within the center portion of recess 11 whereby leads 33 do not engage walls 12-14 and 16. Upwardly projected support shoulders 23, 24, 26 and 27 extend between adjacent ends 30 of ridges 18, 19, 21 and 22. The shoulders support microchip 32 in an elevated position above bottom wall 17 whereby leads 33 do not engage bottom wall 17 nor ridges 18, 19, 21 and 22. A centrally located hole 28 in bottom wall 17 is used to allow optical reading with a light beam to determine presence of microchip 32 in recess 11.

Ridges 18, 19, 21 and 22 are elongated linear members having an inverted V-shape. The length of ridge 18 is substantially the same as the length of ridge 21. The lengths of ridges 19 and 22 are substantially the same and are shorter than the lengths of ridges 18 and 21. Ridges 18, 19, 21 and 22 can have the same lengths. Ridges 18 and 21 extend parallel to and are inwardly spaced from side walls 12 and 14, respectively. Ridges 19 and 22 are inwardly spaced from and extend parallel to end walls 13 and 16, respectively. Ridge 18 is located outwardly from and centered between first ends of ridges 19 and 22. Similarly, ridge 21 is centered between and located outwardly from the opposite ends of ridges 19 and 22. Ridges 18 and 21 are laterally spaced apart at a distance approximately equal to the width of microchip 32. Ridges 19 and 22 are longitudinally spaced apart at a distance approximately equal to the length of microchip 32. Ridges 18, 19, 21 and 22 are engageable with the side walls 34 and 36 and end walls 37 and 38 of microchip 32 to retain the microchip within the central area of recess 11 surrounded by the ridges. This spaces leads 33 from walls 12-14 and 16 of recess 11 thereby preventing damage to the leads.

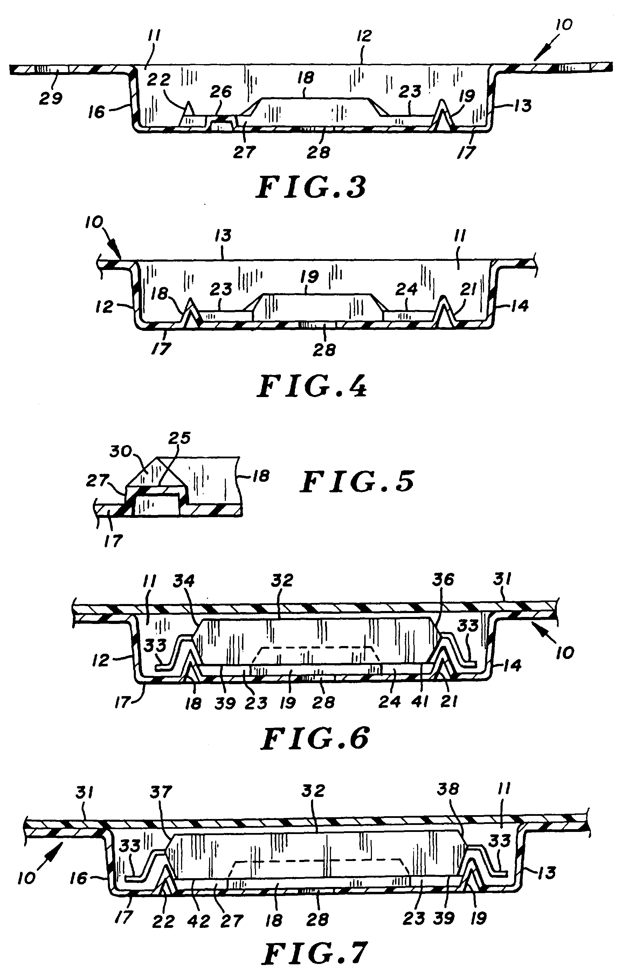

Each ridge 18, 19, 21, 22 has upwardly and inwardly inclined ends 30, as shown in Figure 5. Ends 30 are angularly disposed relative to the longitudinal axis of the ridge whereby the ends of the adjacent ridges face each other. Inclined ends 30 facilitate placement of microchip 32 on shoulder supports 23, 24, 26 and 27.

Shoulders 23, 24, 26 and 27 are generally rectangular members that project upwardly from bottom wall 17. Each shoulder extends diagonally between adjacent ends of ridges 18, 19, 21 and 22. As shown in Figure 5, each shoulder has a generally flat top wall 25 for supporting a corner 39, 41, 42 of microchip 32. Top wall 25 is located above bottom wall 17 of recess 11 whereby microchip 32 is elevated above bottom wall 17. The top edges of ridges 18, 19, 21 and 22 are located above top walls 25 of shoulders 23, 24, 26 and 27. The top portions of the ridges that extend above the shoulders engage microchip walls 34, 36, 37 and 38 to hold the microchip within the central area of recess 11. The corners of microchip 32 are spaced from ends 30 of the ridges.

The microchip 32 of Figure 1 has four corner lobes 35 as stated, and those corner lobes extend outwardly between the spaced ends of adjacent ridges 18,19,21 and 22. Equally, however, the tape of Figures 1 to 5 could be used to store a rectangular microchip without corner lobes, and Figures 6 and 7 show such a microchip without corner lobes, supported in the recess.

Referring to Figures 6 and 7, side walls 34 and 36 and end walls 37 and 38 of microchip 32 have convex shaped outer surfaces. Microchip 32 has generally flat top and bottom surfaces. The inner inclined surfaces of ridges 18, 19, 21 and 22 are complementary to the lower inclined surfaces of microchip walls 34, 36 to 38. This facilitates positioning of microchip 32 within the area surrounded by ridges 18, 19, 21 and 22 in recess 11. The inner inclined surfaces of the ridges cooperate with the lower inclined surfaces of microchip walls 34, 36 to 38 to adjust microchip 32 into the proper storage position within recess 11. For example, when microchip 32 is moved into recess 11 slightly off center toward end wall 19, end wall 38 of the microchip engages the inner surface of wall 19 whereby microchip 32 slides down into a centered position within the recess. The complementary surfaces of ridges 18, 19, 21 and 22 and microchip walls 34, 36 to 38 also function to retain microchip 32 in the centered position within recess 11.

When microchip 32 is in the storage position within recess 11, corners 39, 41 and 42 of microchip 32 are supported on shoulders 23, 24 and 27, respectively, to elevate the microchip above bottom wall 17. Microchip 32 has a fourth corner supported on shoulder 26 in a similar manner. The top portions of ridges 18, 19, 21 and 22 engage microchip walls 34, 36 to 38 to retain the microchip within the central area of recess 11. As shown in Figures 6 and 7, leads 33 connected to microchip walls 34, 36 to 38 extend above the ridges and incline downwardly toward bottom wall 17. The ends of leads 33 are located in a position above bottom wall 17 and are inwardly spaced from walls 12 to 14 and 16 of recess 11. Leads 33 do not engage any structure of tape 10 when microchip 32 is located in the storage position within recess 11 whereby leads 33 are protected from damage. Cover 31 closes the top of recess 11 to hold microchip 32 within the recess when tape 10 is wound on and unwound from a reel. Hole 28 in bottom wall 17 allows the use of a light beam to detect whether recess 11 contains microchip 32.

## Claims

1. A storage tape (10) for accommodating electronic integrated circuit components (32) which are packaged with projecting leads (33), the tape comprising an elongated strip member having a longitudinal row of recesses (11) for storing the components (32), each recess (11) having side walls (12, 13, 14, 16) and a bottom wall (17) but an open top, and having
vertical support means (23, 24, 26, 27) for providing vertical support for the component (32) to be housed in the recess (11), to locate the component (32) over the bottom wall (17) so that its leads (33) are spaced from and free from contact with the bottom wall, and
lateral support means for providing lateral support for the component (32) to be supported on the vertical support means (23, 24, 26, 27), to locate the component (32) within a centre portion of the recess with the leads free from contact with the side walls (12, 13, 14, 16), the lateral support means comprising a plurality of ridges (18, 19, 21, 22) upstanding from the bottom wall (17), parallel to and spaced from the side walls (12, 13, 144, 16), each ridge having an inwardly facing inclined face and opposite end faces (30), the end faces (30) of each pair of adjacent ridges being mutually spaced apart,
CHARACTERISED IN THAT
the vertical support means (23, 24, 26, 27) bridges the spacing between the mutually spaced end faces (30) of the adjacent ridges (18, 19, 21, 22) and is connected to the bottom wall (17) by upstanding walls extending diagonally between adjacent end faces (30) of the ridges (18, 19, 21, 22) from the bottom wall (17) to the vertical support means (23, 24, 26, 27).

2. A storage tape according to claim 1, wherein the opposite end faces (30) of the ridges (18, 19, 21, 22) are upwardly and inwardly inclined.

3. A storage tape according to claim 2, wherein each end face (30) of each ridge, in plan view, is disposed at a non-perpendicular angle to the longitudinal axis of the respective ridge (18, 19, 21 or 22).

4. A storage tape according to any preceding claim, further comprising a cover means releasably attachable to the strip for retaining components (32) in the recesses (11).

5. A storage tape according to any preceding claim, wherein a hole (28) is formed in the bottom wall (17) for enabling the automatic detection of the presence of components (32) in the recesses (11).

6. A combination of a storage tape according to any preceding claim and one or more packaged integrated circuit components (32) accommodated in the recesses (11) therein.

## Patentansprüche

1. Aufbewahrungsband (10) für die Unterbringung elektronischer integrierter Schaltungsbauteile (32), die in einem Gehäuse mit vorstehenden Anschlüssen (33) untergebracht sind, wobei das Band ein langgestrecktes Streifenteil mit einer Längsreihe von Vertiefungen (11) zur Aufbewahrung der Bauteile (32) aufweist und jede Vertiefung (11) Seitenwände (12, 13, 14, 16) und eine Bodenwand (17), aber eine offene Oberseite hat, und mit
vertikalen Abstützmitteln (23, 24, 26, 27) zur vertikalen Abstützung des Bauteils (32), das in der Vertiefung (11) untergebracht werden soll, um das Bauteil (32) über der Bodenwand (17) so anzuordnen, daß seine Anschlüsse (33) beabstandet von und ohne Kontakt mit der Bodenwand sind, und
lateralen Abstützmitteln zur lateralen Abstützung des auf den vertikalen Abstützmitteln (23, 24, 26, 27) abzustützenden Bauteils (32), um das Bauteil (32) in einem zentralen Bereich der Vertiefung mit den Anschlüssen frei von Kontakt zu den Seitenwänden (12, 13, 14, 16) zu positionieren, wobei die lateralen Abstützmittel eine Vielzahl von Rippen (18, 19, 21, 22) aufweisen, die, parallel zu und beabstandet von den Seitenwänden (12, 13, 14, 16), von der Bodenwand (17) hochstehen, wobei jede Rippe eine nach innen gerichtete geneigte Fläche und entgegengesetzte Endflächen (30) hat, wobei die Endflächen (30) jedes Paars benachbarter Rippen voneinander beabstandet sind,
**dadurch gekennzeichnet,** daß
das vertikale Abstützmittel (23, 24, 26, 27) den Zwischenraum zwischen den voneinander beabstandeten Endflächen (30) der benachbarten Rippen (18, 19, 21, 22) überbrückt und mit der Bodenwand (17) durch hochstehende Stege, die sich diagonal zwischen benachbarten Endflächen (30) der Rippen (18, 19, 21, 22) von der Bodenwand (17) zu den vertikalen Abstützmitteln (23, 24, 26, 27) erstrecken, verbunden ist.

2. Aufbewahrungsband gemäß Anspruch 1, bei dem die sich gegenüberliegenden Endflächen (30) der Rippen (18, 19, 21, 22) aufwärts und einwärts geneigt sind.

3. Aufbewahrungsband gemäß Anspruch 2, worin jede Endfläche jeder Rippe, in Draufsicht, in einem nicht rechten Winkel zur Längsachse der Rippe angeordnet ist.

4. Aufbewahrungsband nach einem der vorstehenden Ansprüche, das außerdem eine lösbar an dem Streifen anbringbare Abdeckung aufweist, um die Bauteile (32) in den Vertiefungen (11) zu halten.

5. Aufbewahrungsband nach einem der vorstehenden Ansprüche, worin in der Bodenwand (17) ein Loch (28) ausgebildet ist, um den automatischen Nachweis der Anwesenheit von Baueilen in der Vertiefung zu ermöglichen.

6. Kombination aus einem Aufbewahrungsband nach einem der vorstehenden Ansprüche und einem oder mehreren mit Gehäuse versehenen integrierten Schaltungsbauteilen, die in den darin vorhandenen Vertiefungen (11) untergebracht sind.

## Revendications

1. Ruban de stockage (10) pour recevoir des composants de circuits intégrés électroniques (32), dans lesquels sont implantés des conducteurs en saillie (33), le ruban comprenant un élément de bande allongé ayant une rangée longitudinale d'évidements (11) pour stocker les composants (32), chaque évidement (11) ayant des parois latérales (12, 13, 14, 16) et une paroi de fond (17), mais un haut ouvert, et ayant
des moyens de support verticaux (23, 24, 26, 27) pour fournir un support vertical au composant (32) à loger dans l'évidement (11), afin de positionner le composant (32) au-dessus de la paroi de fond (17) de façon que ses conducteurs (33) soient espacés de la paroi de fond et ne soient pas en contact avec elle, et
des moyens de support latéraux pour fournir un support latéral au composant (32) à supporter sur les moyens de support verticaux (23, 24, 26, 27) afin de positionner le composant (32) à l'intérieur d'une portion centrale de l'évidement avec ses conducteurs sans contact avec les parois latérales (12, 13, 14, 16), les moyens de support latéraux comprenant une multiplicité d'arêtes (18, 19, 21, 22) partant verticalement de la paroi de fond (17), parallèles aux parois latérales (12, 13, 14, 16) et espacées de celles-ci, chaque arête ayant une face inclinée regardant vers l'intérieur et des faces terminales opposées (30), les faces terminales (30) de chaque paire d'arêtes adjacentes étant espacées l'une de l'autre,
caractérisé en ce que
les moyens de support verticaux (23, 24, 26, 27) recouvrent l'espace entre les faces terminales espacées l'une de l'autre (30) d'arêtes adjacentes (18, 19, 21, 22) et sont raccordés à la paroi de fond (17) par des parois verticales s'étendant en diagonale entre des faces terminales adjacentes (30) des arêtes (18, 19, 21, 22) en partant de la paroi de fond (17) jusqu'aux moyens supports verticaux (23, 24, 26, 27).

2. Ruban de stockage selon la revendication 1, dans lequel les faces terminales opposées (30) des arêtes (18, 19, 21, 22) sont inclinées vers le haut et vers l'intérieur.

3. Ruban de stockage selon la revendication 2, dans lequel chaque face terminale de chaque arête, vue en plan, est disposée en faisant un angle non droit avec l'axe longitudinal de l'arête.

4. Ruban de stockage selon l'une des revendications précédentes, comprenant en outre un moyen de recouvrement pouvant être fixé de façon amovible sur la bande pour retenir les composants (32) dans les évidements (11).

5. Ruban de stockage selon l'une des revendications précédentes, dans lequel un trou (28) est formé dans la paroi de fond (17) pour permettre la détection automatique de la présence de composants en les évidements.

6. Combinaison d'un ruban de stockage selon l'une des revendications précédentes et d'un ou plusieurs composants de circuits intégrés emballés logés dans les évidements (11) de ce ruban de stockage.
